Europäisches Patentamt

European Patent Office

Office européen des brevets

(11) Veröffentlichungsnummer : **0 311 063 B1**

(12) # EUROPÄISCHE PATENTSCHRIFT

(45) Veröffentlichungstag der Patentschrift :
**19.07.95 Patentblatt 95/29**

(51) Int. Cl.$^6$ : **G03F 7/30**

(21) Anmeldenummer : **88116518.7**

(22) Anmeldetag : **06.10.88**

(54) **Verfahren und Vorrichtung zum Behandeln eines photographischen Aufzeichnungsmaterials.**

(30) Priorität : **09.10.87 DE 3734097**

(43) Veröffentlichungstag der Anmeldung :
**12.04.89 Patentblatt 89/15**

(45) Bekanntmachung des Hinweises auf die
Patenterteilung :
**19.07.95 Patentblatt 95/29**

(84) Benannte Vertragsstaaten :
**AT BE CH DE ES FR GB IT LI LU NL SE**

(56) Entgegenhaltungen :
**DE-A- 3 007 401**
**DE-A- 3 521 135**
**US-A- 3 906 536**
**PATENT ABSTRACTS OF JAPAN vol. 8, no.**
**109 (P-275)(1546) 22 Mai 1984, & JP-A-59 18946**
**PATENT ABSTRACTS OF JAPAN vol. 11, no.**
**201 (P-590)(2648) 30 Juni 1987 & JP-A-62 21154**

(73) Patentinhaber : **DU PONT DE NEMOURS**
**(DEUTSCHLAND) GMBH**
**Du Pont Strasse 1**
**D-61352 Bad Homburg (DE)**
(84) **BE CH DE ES LI LU NL SE AT**
Patentinhaber : **E.I. DU PONT DE NEMOURS**
**AND COMPANY**
**1007 Market Street**
**Wilmington Delaware 19898 (US)**
(84) **FR GB IT**

(72) Erfinder : **Ganzke, Jürgen, Dr.**
**Rheinstrasse 6**
**D-6057 Dietzenbach (DE)**
Erfinder : **Jahn, Dieter**
**Bahnhofstrasse 47**
**D-6078 Neu-Isenburg (DE)**
Erfinder : **Kritzner, Bruno**
**Am Gerauer Weg 21**
**D-6087 Büttelborn (DE)**

(74) Vertreter : **Pistor, Wolfgang**
**Du Pont de Nemours (Deutschland) GmbH**
**Patentabteilung**
**Dornhofstrasse 10**
**D-63263 Neu-Isenburg (DE)**

## Beschreibung

Die Erfindung betrifft ein Verfahren und eine Vorrichtung zum Behandeln eines photographischen Aufzeichnungsmaterials durch Auswaschen ungehärteter Bereiche bildmäßig gehärteter auf einem Schichtträger angeordneter Aufzeichnungsschichten. Solche Aufzeichnungsschichten lassen sich beispielsweise durch Gerbentwicklung von Silberhalogenidemulsionen in hydrophilen Kolloiden, durch Photopolymerisation geeigneter lichtempfindlicher Gemische (meist negativ arbeitend) oder auch auf der Basis von Chinondiazid-Novolak-Systemen (meist positiv arbeitend) herstellen.

Bei einer bekannten Vorrichtung zur Durchführung eines solchen Verfahrens (DE 27 02 335 C3) wird das Aufzeichnungsmaterial durch ein Paar eingangsseitiger Walzen in die Vorrichtung eingeführt. Während es über eine aus Drähten bestehende Filmführung gleitet, wird das fluide Auswaschmittel unter hohem Druck und mit hoher Geschwindigkeit aus zwei Düsenreihen auf seine Aufzeichnungsschicht gespritzt. Schließlich verläßt das Aufzeichnungsmaterial die Auswaschvorrichtung durch ein weiteres Walzenpaar.

Werden mit einer solchen Vorrichtung bildmäßig gehärtete Aufzeichnungsschichten ausgewaschen, dann weist das fertige Bild eine mehr oder weniger gut erkennbare Streifenstruktur in der Richtung des Transports durch die Auswaschvorrichtung auf. Diese Struktur ist bei Strichzeichnungen und Buchstabentexten zwar häufig kaum erkennbar und wird dann toleriert, wirkt jedoch bei Rasterbildern äußerst störend, insbesondere wenn diese nur geringe Kontraste und große Flächen glatter Töne aufweisen.

Die Erfindung stellt sich daher die Aufgabe, ein Verfahren zum Behandeln eines photographischen Aufzeichnungsmaterials durch Auswaschen anzugeben, welches Bilder hervorbringt, die von dem beschriebenen Fehler frei sind.

Diese Aufgabe wird durch ein Verfahren nach dem kennzeichnenden Teil des Hauptanspruchs gelöst. Es wurde nämlich gefunden, daß sich bildmäßig gehärtete photographische Aufzeichnungsschichten ohne Bildung störender Streifenmuster auswaschen lassen, wenn das Aufzeichnungsmaterial nacheinander durch mindestens zwei durch Trennelemente begrenzte und voneinander getrennte, jeweils mit gesonderten Düsenanordnungen versehene Auswaschbereiche geführt wird, wenn es während des Auswaschens im wesentlichen eben geführt wird, wenn in jedem Auswaschbereich die Düsen so geformt und angeordnet sind, daß jedes Flächenelement der Aufzeichnungsschicht nacheinander von mindestens zwei Spritzkegeln getroffen wird, die Spritzkegel selbst sich jedoch vor dem Auftreffen auf die Aufzeichnungsschicht nicht berühren und wenn die Menge des pro Zeiteinheit auf die Flächeneinheit der Aufzeichnungsschicht auftreffenden Auswaschmittels und seine Auftreffgeschwindigkeit so gewählt werden, daß einerseits alle bildfreien Bereiche, andererseits jedoch keine bildtragenden Bereiche ausgewaschen werden.

Die erwähnten Trennelemente brauchen dabei die Auswaschbereiche nicht zu umschließen. Sie sollen lediglich verhindern, daß Auswaschmittel vor oder nach dem Auftreffen auf die Aufzeichnungsschicht von einem Auswaschbereich in einen anderen Auswaschbereich oder in einen vor oder hinter der Auswaschvorrichtung befindlichen Bereich übertritt. Besonders geeignet sind auf der Aufzeichnungsschicht aufliegende und entsprechend der Transportgeschwindigkeit des Aufzeichnungsmaterials rotierende Walzen. So können beispielsweise die an Eingang und Ausgang der bekannten Auswaschvorrichtung (DE 27 02 335 C3) auf der Aufzeichnungsschicht aufliegenden Walzen zur Begrenzung des ersten bzw. letzten Auswaschbereiches nach außen dienen, während zur Trennung der Auswaschbereiche voneinander weitere auf der Aufzeichnungsschicht aufliegende Walzen angeordnet werden. Die Auswaschbereiche können aber auch durch Lippen aus elastischem Material oder durch Luftbürsten begrenzt und voneinander getrennt werden. Selbstverständlich können auch Trennelemente verschiedener Art in einer Auswaschvorrichtung kombiniert werden.

Es ist vorteilhaft, das Aufzeichnungsmaterial in den Auswaschbereichen im wesentlichen waagrecht zu führen. Zur ebenen und waagrechten Führung kann das Aufzeichnungsmaterial auf dem waagrechten Teil eines Transportbandes ruhen, welches seinerseits durch die Auswaschvorrichtung hindurchbewegt wird. Dieses kann aus flexiblem Material oder auch aus Gliedern bestehen. Um eine ebene Führung des Aufzeichnungsmaterials und des Transportbandes zu gewährleisten, läßt man dieses zweckmäßig innerhalb der Auswaschbereiche über ebene Tische gleiten. Transportband und Tische können in bekannter Weise Löcher aufweisen, welche das Abfließen des Auswaschmittels ermöglichen. Anstelle einzelner Tische wird vorteilhaft auch ein einziger Tisch verwendet, der sich über mehrere Auswaschbereiche erstreckt.

Als Auswaschmittel werden für gerbentwickelte Aufzeichnungsschichten auf der Basis von hydrophilen Kolloiden wie z.B. Gelatine vorzugsweise Wasser oder wäßrige Lösungen verwendet, welche auf eine Temperatur erwärmt sind, die deutlich oberhalb des Schmelzpunktes des entsprechenden Hydrogels liegt. Bei Gelatineschichten liegt diese Temperatur zweckmäßig zwischen 20 und 50° C. Für andere Auswaschfilme, insbesondere auf der Basis von Photopolymeren, können aber auch nichtwäßrige Lösungsmittel angemessener Temperatur in Frage kommen.

Eine Düsenanordnung für einen Auswaschbereich, welche erfindungsgemäß ermöglicht, daß jedes Flächenelement der Aufzeichnungsschicht nacheinander von mindestens zwei Spritzkegeln getroffen wird, die sich jedoch vor dem Auftreffen auf die Aufzeichnungsschicht gegenseitig nicht berühren sollen, läßt sich zum Beispiel durch mehrere in der Transportrichtung hintereinanderliegende und quer zu dieser Richtung versetzte Reihen von Düsen mit rotationssymmetrischen Spritzkegeln realisieren. Eine andere bevorzugte Ausgestaltung besteht aus einer Reihe von Flachstrahldüsen, bei denen die größten Durchmesser der Flachstrahlen so gegen die Transportrichtung gedreht sind und deren Abstand so bemessen ist, daß das genannte erfindungsgemäße Merkmal erfüllt ist. Besonders bevorzugt wird eine Anordnung, bei der die Spritzkegel einen öffnungswinkel von 60 bis 120 Grad in der Richtung des größten Durchmessers haben und die größten Durchmesser mit der Transportrichtung einen Winkel von 75 bis 85 Grad bilden.

Zur Lösung der gestellten Aufgabe reicht es im allgemeinen nicht aus, das Auswaschmittel in bekannter Weise mit hohem Druck und hoher Geschwindigkeit auf die Aufzeichnungsschicht zu spritzen. Auftreffgeschwindigkeit und Menge des je Zeiteinheit auf die Flächeneinheit der auszuwaschenden Aufzeichnungsschicht auftreffenden Auswaschmittels müssen vielmehr so gewählt werden, daß nur die bildfreien, d. h. ungehärteten Teile der Aufzeichnungsschicht entfernt werden und die bildtragenden, d. h. gehärteten Bereiche vollständig im Aufzeichnungsmaterial erhalten bleiben. Erfahrungsgemäß führt zu hohe Auftreffgeschwindigkeit zum teilweisen Auswaschen gehärteter Bereiche, sodaß auf Grund der im allgemeinen ungleichmäßigen Verteilung der Auftreffgeschwindigkeit auf dem verarbeiteten Aufzeichnungsmaterial Längsstreifen entstehen, die gegenüber einem fehlerlosen Bild mehr oder weniger stark aufgehellt sind. Analog bilden sich bei zu niedriger Auftreffgeschwindigkeit dunkle Längsstreifen.

Die geeignete Kombination von Auftreffgeschwindigkeit und Menge des Auswaschmittels wird naturgemäß durch die Art der Aufzeichnungsschicht bestimmt. Für eine gerbentwickelte Silberhalogenidemulsionsschicht auf Gelatinebasis wird der Bereich von 15 bis 30 m/s für die Auftreffgeschwindigkeit und von 0,8 bis 2 ml je s und cm$^2$ für die Menge des Auswaschmittels bevorzugt.

Der Anwendungsbereich der Erfindung umfaßt photographische Aufzeichnungsmaterialien beliebiger Art mit bildmäßig gehärteten auswaschbaren Aufzeichnungsschichten, insbesondere negativ oder positiv arbeitende Kopierfilme und Druckplatten auf der Basis hydrophiler Kolloide oder photopolymerer Gemische.

Die Erfindung wird im folgenden mit Hilfe eines in den Zeichnungen dargestellten bevorzugten Ausführungsbeispiels näher erläutert. Es zeigen:

Fig. 1    einen Längsschnitt durch eine zur Durchführung des Verfahrens geeignete Vorrichtung,

Fig. 2    die Anordnung der von den einzelnen Spritzkegeln einer Reihe von Flachstrahldüsen getroffenen Bereiche der Aufzeichnungsschicht

Fig. 3    die Anordnung der von den Spritzkegeln dreier Reihen von Rundstrahldüsen getroffenen Bereiche der Aufzeichnungsschicht.

Die Auswaschvorrichtung ist im allgemeinen mit Vorrichtungen für andere Behandlungsstufen, z. B. Entwickeln und Trocknen, die hier nicht dargestellt sind, in einer Behandlungseinheit integriert. Sie ist in einem Gehäuse untergebracht, welches aus einem Oberteil 1 und einem Unterteil 2 besteht. Beide Teile sind mit flexiblen Lippen 3a und 3b bzw. 4a und 4b zur Abdichtung gegen verspritzendes Auswaschmittel versehen. An der Eingangsseite der Vorrichtung befinden sich zwei rotierende Walzen 5 und 6, von denen wenigstens eine federnd gelagert ist, so daß sich der Spalt zwischen ihnen selbsttätig schließt und auf das auszuwaschende Aufzeichnungsmaterial 20 eine zum Transport ausreichende Reibungskraft übertragen wird. An der Ausgangsseite der Vorrichtung sind ebenfalls zwei rotierende Walzen 7 und 8 vorhanden, von denen wiederum mindestens eine federnd gelagert ist. Über die Walzen 5 und 7 läuft ein endloses Transportband 9 aus einem flexiblen Material, welches über einen festen Tisch 10 mit waagrechter Oberfläche gleitet. In der Vorrichtung sind zwei Auswaschbereiche 11 und 12 vorhanden, die durch eine federnd gelagerte Walze 13 getrennt sind. Diese liegt auf dem Transportband 9 bzw. dem Aufzeichnungsmaterial 20 auf und wird so in Rotation versetzt. Eine im Auswaschbereich 11 aufliegende Schicht des Auswaschmittels wird dadurch entfernt, bevor das Aufzeichnungsmaterial in den Auswaschbereich 12 eintritt. Etwa in der Mitte des Auswaschbereichs 11 befindet sich über dem Transportband 9 ein Düsenrohr 15, welches eine Reihe von Flachstrahldüsen 14 trägt, die das Auswaschmittel in Form von Spritzkegeln 16 nach unten auf das Transportband 9 bzw. das auf diesem liegende Aufzeichnungsmaterial 20 spritzen. Dadurch werden ungehärtete Teile der auf dem Schichtträger 21 haftenden Aufzeichnungsschicht 22 gelöst und durch das Auswaschmittel weggespült. In analoger Weise ist im zweiten Auswaschbereich 12 ein Düsenrohr 15a mit einer Reihe von Düsen 14a vorhanden. Das Auswaschmittel fällt danach über den Rand des Transportbandes 9 oder auch durch Löcher im Transportband und im Tisch 10 in das Unterteil 2 des Gehäuses und verläßt dieses durch einen Abfluß 23. Es kann dann verworfen oder durch hier nicht gezeigte Filter und Heizelemente aufbereitet und mittels einer Pumpe wieder den Düsenrohren 15 und 15a zugeführt werden.

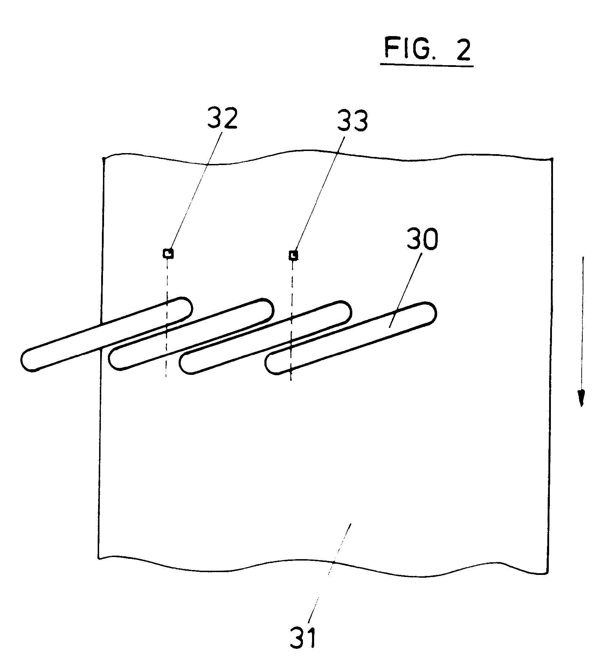

In Fig. 2 sind die von den einzelnen Spritzkegeln der Flachstrahldüsen eines Auswaschbereiches getroffenen Bereiche 30 auf der Aufzeichnungsschicht dargestellt. Es ist ersichtlich, daß bei Bewegung des Aufzeichnungsmaterials in Pfeilrichtung jedes Flächemelement der Oberfläche 31, beispielsweise die Flächenelemente 32 und 33, nacheinander von mindestens zwei Spritzkegeln getroffen wird.

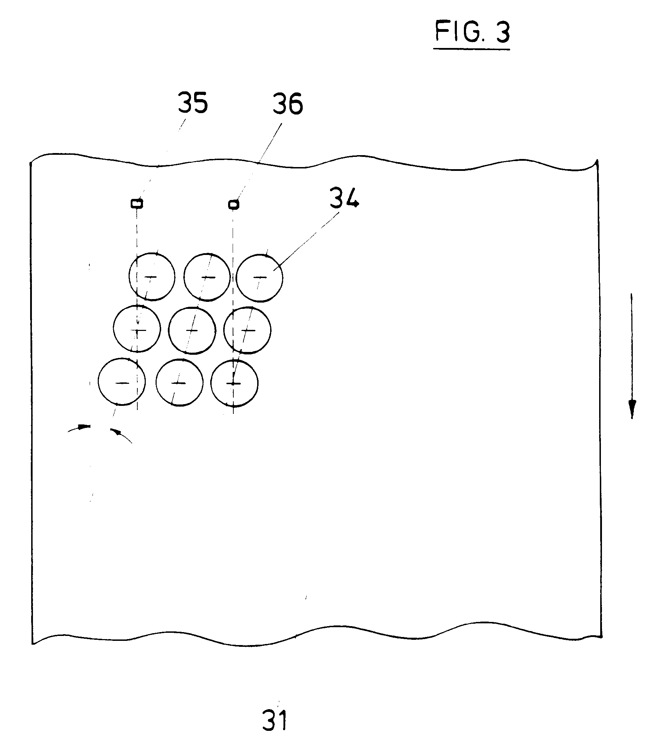

Fig. 3 zeigt eine mögliche Anordnung von Runstrahldüsen. Diese sind an drei Düsenrohren so angebracht, daß die Düsen eines jeden Düsenrohrs gegenüber denen der anderen Düsenrohre in einer Richtung senkrecht zur Transportrichtung des Transportbandes um ein Drittel ihres Abstandes in dieser Richtung versetzt sind. Auch hierbei werden beispielsweise die Flächenelemente 35 und 36 von jeweils mindestens zwei Spritzkegeln 34 getroffen.

Die folgende Versuchsbeschreibung soll das erfindungsgemäße Verfahren noch weiter beispielhaft erläutern:

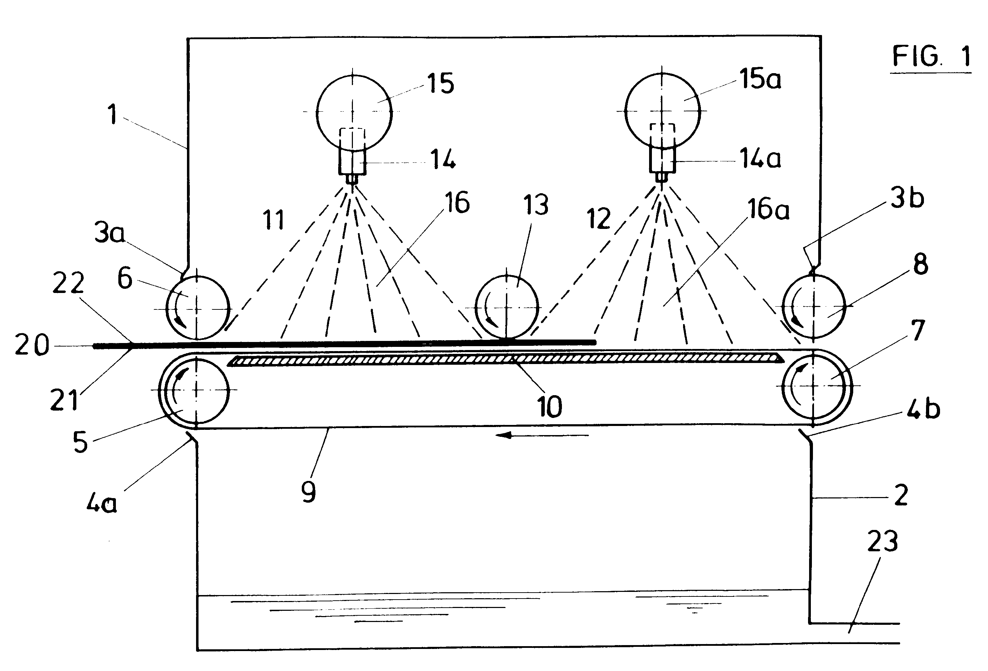

Ein für Gerbentwicklung und Auswaschen geeignetes photographisches Aufzeichnungsmaterial wurde in gleicher Weise wie der Vergleichsfilm in Beispiel 1 der EP 01 28 836-A2 hergestellt und im Kontakt mit einem fünfzigprozentigem Rasterton (60 Linien/cm) belichtet. Die Verarbeitung erfolgte in einer integrierten Behandlungseinheit, in der das Aufzeichnungsmaterial mit Hilfe von Förderwalzen nacheinander durch ein Aktivierungs-, ein Auswasch- und ein Trockenteil gefördert wurde. Das Auswaschteil der Vorrichtung war entsprechend Fig. 1 gebaut, jedoch konnten die erfindungswesentlichen Parameter verändert werden. Die Aktivierung erfolgte 15 s lang in einem Aktivator von 40° C, die Fixage 15 s in einem Fixierbad von 25° C. Die Zusammensetzung der Bäder ist ebenfalls in Beispiel 1 der genannten Europäischen Patentanmeldung angegeben. Nach dem Auswaschen wurde das Aufzeichnungsmaterial 20 s in einem Luftstrom von 55° C getrocknet.

Die Anordnung der Bauelemente in der Auswaschvorrichtung entsprach zunächst der Fig. 1. Dabei betrug der Abstand der Düsenrohre 15 und 15a vom Transportband 70 mm, der Abstand der Walze 13 von den Walzen 6 und 8 jeweils 100 mm und der Abstand zweier benachbarter Flachstrahldüsen an einem Düsenrohr jeweils 25 mm. Als Auswaschmittel diente Wasser mit einer Temeperatur von 35°C, das mit einer Geschwindigkeit von 22 m/s und in einer Menge von 1,5 ml je s und cm$^2$ auf die Aufzeichnungsschicht gespritzt wurde. Die Geschwindigkeit des Transportbandes betrug 0,03 m/s. Der von den Spritzstrahlen auf das Transportband bzw. die Aufzeichnungsschicht ausgeübte Druck betrug ca. 300 Pa. Die größten Durchmesser der Spritzkegel bildeten mit der Transportrichtung einen Winkel von 80 Grad. Unter diesen Bedingungen wurde ein völlig gleichmäßiger 50%-Rasterton erhalten.

Nun wurden, jeweils von diesem erfindungsgemäßen Zustand ausgehend, eine Reihe von Veränderungen vorgenommen, wodurch die im folgenden aufgeführten Fehler am verarbeitenten Aufzeichnungsmaterial auftraten:

```
Änderung                                    Ergebnis

1. Stillegen eines der beiden               Dunkle Längsstreifen im Abstand
   Düsenrohre                               der Düsen


2. Vermindern von Aufspritzge-              Dunkle Längsstreifen im Abstand
   schwindigkeit und Menge des             der Düsen
   Wassers um 50%


3. Steigern von Aufspritzge-                Unregelmäßige helle Flecken
   schwindigkeit und Menge des
   Wassers um 100%


4. Einstellen der Flachstrahldüsen          Helle und dunkle Längsstreifen
   in einen Winkel von 90 Grad zur
   Transportrichtung (Spritzkegel
   berühren sich vor dem Auftreffen)


5. Ersatz von Förderband 9 und              Dunkle Längsstreifen im Abstand
   Tisch 10 durch in Transport-             der Drähte; Kratzer auf der
   richtung gespannte Drähte                Rückseite


6. Herausnehmen der Walze 13                Helle und dunkle Flecken;
                                            Flattern und/oder Aufschwimmen
                                            des Aufzeichnungsmaterials;
                                            Aussetzen des Transports
```

Die Ergebnisse dieses Versuchs zeigen, daß fehlerfreie Bilder nur durch das Zusammenwirken der erfindungsgemäßen Merkmale erhalten werden.

## Patentansprüche

1. Verfahren zum Behandeln eines photographischen Aufzeichnungsmaterials, welches aus einem Schichtträger und mindestens einer bildmäßig gehärteten Aufzeichnungsschicht besteht, bei dem die bildfreien Stellen dieser Aufzeichnungsschicht durch Auswaschen entfernt werden, wobei das Aufzeichnungsmaterial unter einer ein- oder mehrreihigen Anordnung von im wesentlichen senkrecht nach unten Auswaschmittel spritzenden Düsen durchgeführt wird,
dadurch gekennzeichnet, daß
   a) das Aufzeichnungsmaterial nacheinander durch mindestens zwei durch Trennelemente begrenzte und voneinander getrennte, jeweils mit gesonderten Düsenanordnungen versehene Auswaschbereiche geführt wird,
   b) das Aufzeichnungsmaterial während des Auswaschens im wesentlichen eben geführt wird,
   c) in jedem Auswaschbereich die Düsen so geformt und angeordnet sind, daß jedes Flächenelement der Aufzeichnungsschicht nacheinander von mindestens zwei Spritzkegeln getroffen wird, die Spritzkegel selbst sich jedoch vor dem Auftreffen auf die Aufzeichnungsschicht nicht berühren und

d) die Menge des pro Zeiteinheit auf die Flächeneinheit des Aufzeichnungsmaterials auftreffenden Auswaschmittels und seine Auftreffgeschwindigkeit so gewählt werden, daß einerseits alle bildfreien Bereiche, andererseits jedoch keine bildtragenden Bereiche der Aufzeichnungsschicht entfernt werden.

2. Verfahren nach Anspruch 1, dadurch gekennzeichnet, daß die Aufzeichnungsschicht aus einer bildmäßig belichteten negativ oder positiv arbeitenden Photopolymerschicht besteht.

3. Verfahren nach Anspruch 1, dadurch gekennzeichnet, daß die Aufzeichnungsschicht aus einer bildmäßig belichteten und gerbentwickelten Silberhalogenid-Emulsionsschicht besteht.

4. Verfahren nach Anspruch 1 bis 3, dadurch gekennzeichnet, daß als Trennelemente auf der auszuwaschenden Aufzeichnungsschicht aufliegende rotierende Walzen verwendet werden.

5. Verfahren nach Anspruch 1 bis 4, dadurch gekennzeichnet, daß das Aufzeichnungsmaterial während des Auswaschens im wesentlichen waagerecht geführt wird.

6. Verfahren nach Anspruch 1 bis 5, dadurch gekennzeichnet, daß das Aufzeichnungsmaterial während des Auswaschens auf dem waagrechten Teil eines durch die Auswaschvorrichtung sich bewegenden Transportbandes ruht.

7. Verfahren nach Anspruch 6, dadurch gekennzeichnet, daß das Transportband zumindest in den Auswaschbereichen der Auswaschvorrichtung von einem waagrechten Tisch gestützt wird.

8. Verfahren nach Anspruch 6 oder 7, dadurch gekennzeichnet, daß das Transportband und ggf. der Tisch Löcher zum Durchlassen des Auswaschmittels aufweisen.

9. Verfahren nach Anspruch 1 bis 8, dadurch gekennzeichnet, daß als Auswaschmittel Wasser oder eine wäßrige Lösung verwendet wird.

10. Verfahren nach Anspruch 9, dadurch gekennzeichnet, daß das Wasser oder die wäßrige Lösung eine Temperatur von 20 bis 50° C hat.

11. Verfahren nach Anspruch 1 bis 10, dadurch gekennzeichnet, daß als die Düsen Flachstrahldüsen sind.

12. Verfahren nach Anspruch 11, dadurch gekennzeichnet, daß der Öffnungswinkel der Spritzkegel in der Richtung ihrer größten Durchmesser 60 bis 120 Grad beträgt.

13. Verfahren nach Anspruch 12 oder 13, dadurch gekennzeichnet, daß die Richtung der größten Durchmesser der Spritzkegel mit der Transportrichtung des Aufzeichnungsmaterials einen Winkel von 75 bis 85 Grad bildet.

14. Verfahren nach Anspruch 3 bis 13, dadurch gekennzeichnet, daß das Auswaschmittel mit einer Geschwindigkeit von 15 bis 30 m/s und in einer Menge von 0,8 bis 2 ml je s und $cm^2$ auf die Aufzeichnungsschicht gespritzt wird.

15. Verfahren nach Anspruch 1 bis 14, dadurch gekennzeichnet, daß die Aufzeichnungsschicht ein Rasterbild aufweist.

16. Vorrichtung zur Durchführung des Verfahrens nach Anspruch 1 bis 15, welche eingangs- und ausgangsseitig angeordnete Förder- oder Haltewalzen, eine Filmtransportführung und ein oder mehrere mit im wesentlichen senkrecht nach unten gerichteten Düsen versehene Düsenrohre aufweist, dadurch gekennzeichnet, daß

a) in dem durch die Förder- oder Haltewalzen der Eingangs- bzw. Ausgangsseite begrenzten Arbeitsbereich mindestens ein Trennelement vorhanden ist, wodurch mindestens zwei Auswaschbereiche gebildet werden,

b) als Filmtransportführung ein ggf. endloses Transportband, welches durch die Förderwalzen der Eingangs- und/oder Ausgangsseite angetrieben wird, vorhanden ist,

c) in jedem Auswaschbereich mindestens ein Düsenrohr vorhanden ist, wobei die Düsen so angeordnet

6

sind, daß jedes Flächenelement des Transportbandes bei einem Durchlauf durch diesen Auswaschbereich von mindestens zwei Spritzkegeln getroffen wird, die Spritzkegel sich jedoch vor dem Auftreffen auf das Transportband nicht berühren.

17. Vorrichtung nach Anspruch 16, dadurch gekennzeichnet, daß in mindestens einem Auswaschbereich ein Düsenrohr vorhanden ist, das mit Flachstrahldüsen versehen ist, bei denen der größte Durchmesser der Spritzkegel mit der Laufrichtung des Transportbandes einen Winkel von 75 bis 85 Grad bildet und der Öffnungswinkel der Spritzkegel in der Richtung des größten Durchmessers 60 bis 120 Grad beträgt.

18. Vorrichtung nach Anspruch 16, dadurch gekennzeichnet, daß die Düsen Rundstrahldüsen sind und in mindestens einem Auswaschbereich drei Düsenrohre so angeordnet sind, daß die Düsen jedes Düsenrohrs gegenüber denen der anderen Düsenrohre in einer Richtung senkrecht zur Transportrichtung des Transportbandes um ein Drittel ihres Abstandes in dieser Richtung versetzt sind.

## Claims

1. A process for treating a photographic recording material consisting of a carrier and at least one imagewise hardened recording layer, wherein the areas of said recording layer free of image are removed by washing-out, and wherein the recording material is being conveyed beneath an arrangement of one or more rows of jets spraying the washing agent essentially vertically downwards,
characterized in that
a) the recording material is sequentially conveyed through at least two wash sections bounded and separated from each other by seperating elements, each wash section being provided with separate jet arrangements,
b) the recording material is conveyed essentially flat during washing-out,
c) in each wash section the jets are formed and arranged so that each surface element of the recording layer is sequentially struck by at least two spray cones, said spray cones do not come into contact with each other before impacting the recording layer, and
d) the amount of the washing agent impacting a unit area of the recording material per unit time and the impacting velocity are selected so that all image-free areas but none of the image-carrying areas of the recording layer are removed.

2. A process according to claim 1,
characterized in that
the recording layer consists of an imagewise exposed negative or positive acting photopolymerizable layer.

3. A process according to claim 1,
characterized in that
the recording layer consists of an imagewise exposed and tanning developed silver halide emulsion layer.

4. A process according to claim 1 to 3,
characterized in that
rotating rolls, resting on the recording layer to be washed out, are used as seperating elements.

5. A process according to claim 1 to 4,
characterized in that
the recording material is conveyed essentially horizontally during washing.

6. A process according to claim 1 to 5,
characterized in that
the recording material during washing rests on the horizontal part of a conveyer belt moving through the washing device.

7. A process according to claim 6,
characterized in that
the conveyer belt is supported by a horizontal table at least in the wash sections of the washing device.

8. A process according to claim 6 or 7,
characterized in that
the conveyor belt and optionally the table exhibit holes to permit passing-through of the washing agent.

9. A process according to claim 1 to 8,
characterized in that
water or an aqueous solution is used as washing agent.

10. A process according to claim 9,
characterized in that
the water or the aqueous solution has a temperature of 20 to 50 °C.

11. A process according to claim 1 to 10,
characterized in that
the jets are fan spray jets.

12. A process according to claim 11,
characterized in that
the generating angle of the spray cones in the direction of their largest diameters is 60 to 120 degrees.

13. A process according to claim 11 or 12,
characterized in that
the direction of the largest diameters of the spray cones makes an angle of 75 to 85 degrees with the direction of transport of the recording material.

14. A process according to claim 3 to 13,
characterized in that
the washing agent is sprayed onto the recording layer with a velocity of 15 to 30 m/s and in an amount of 0,8 to 2 ml per s and cm$^2$.

15. A process according to claim 1 to 14,
characterized in that
the recording layer contains a halftone image.

16. A device for carrying out a process according to claim 1 to 15, which comprises transport or support rolls arranged at the entrance and at the exit sides, a film transport guide, and one or more jet tubes equipped with jets directed essentially vertically downwards,
characterized in that
a) in the working area bounded by the transport or support rolls at the entrance and at the exit sides at least one seperating element is present by which at least two wash sections are formed,
b) as film transport guide a conveyor belt is present, which is optionally endless, and which is driven by the transport rolls at the entrance and/or the exit side,
c) in each wash section at least one jet tube is present, the downward directed jets being arranged such that each surface element of the conveyor belt is impacted by at least two spray cones as it passes through said wash section, and the spray cones do not come into contact with each other before impacting the conveyor belt.

17. A device according to claim 16,
characterized in that
at least in one wash section a jet tube equipped with fan jets is present, wherein the largest diameter of the spray cones make an angle of 75 to 85 degrees with the moving direction of the conveyor belt and wherein the generating angle of the spray cones in the direction of their largest diameter is 60 to 120 degrees.

18. A device according to claim 16,
characterized in that
the jets are circular spray jets and in at least one wash section three jet tubes are arranged so that the jets of each jet tube in relation to those of the other jet tubes are displaced in a direction perpendicular to the moving direction of the conveyor belt by one third of their distance in this direction.

## Revendications

1. Procédé pour le traitement d'un matériau d'enregistrement photographique, composé d'un support des couches et d'au moins une couche d'enregistrement durcie en correspondance avec une image, dans lequel les zones sans image de cette couche d'enregistrement sont éliminées par rinçage, le matériau d'enregistrement étant guidé en-dessous d'un agencement à une ou plusieurs rangées de buses pulvérisant un agent de rinçage de façon sensiblement verticale vers le bas, caractérisé en ce que

a) le matériau d'enregistrement est guidé successivement à travers au moins deux zones de rinçage séparées l'une de l'autre et délimitées par des éléments de séparation et munies chacune d'agencement de buses particuliers,

b) le matériau d'enregistrement est guidé de manière sensiblement plane pendant le rinçage,

c) dans chaque zone de rinçage, les buses sont formées et disposées de telle façon que chaque élément plan de la couche d'enregistrement soit frappé successivement par au moins deux cônes de pulvérisation, les cônes de pulvérisation ne venant cependant pas en contact avant l'impact sur la couche d'enregistrement, et

d) on choisit la quantité par unité de temps de l'agent de rinçage venant frapper l'unité de surface du matériau d'enregistrement, ainsi que sa vitesse d'impact de telle façon que, d'une part, toutes les zones exemptes d'image soient éliminées, mais que cependant aucune zone de la couche d'enregistrement portant une image ne soit éliminée.

2. Procédé selon la revendication 1, caractérisé en ce que la couche d'enregistrement se compose d'une couche de photopolymère exposée en correspondance avec une image et servant de négatif ou de positif.

3. Procédé selon la revendication 1, caractérisé en ce que la couche d'enregistrement se compose d'une couche d'une émulsion d'halogénure d'argent exposée en correspondance avec une image et développée au bain tannant.

4. Procédé selon la revendication 1 à 3, caractérisée en ce qu'on utilise, en tant qu'éléments de séparation, des rouleaux rotatifs reposant sur la couche d'enregistrement à éliminer par rinçage.

5. Procédé selon la revendication 1 à 4, caractérisé en ce que le matériau d'enregistrement est guidé pendant le rinçage de façon sensiblement horizontale

6. Procédé selon la revendication 1 à 5, caractérisé en ce que le matériau d'enregistrement repose, pendant le rinçage, sur la partie horizontale d'une bande transporteuse se déplaçant à travers le dispositif de rinçage.

7. Procédé selon la revendication 6, caractérisé en ce que la bande transporteuse est supportée, au moins dans les zones de rinçage du dispositif de rinçage, au moyen d'une table horizontale.

8. Procédé selon la revendication 6 ou 7, caractérisé en ce que la bande transporteuse et, le cas échéant, la table comportent des trous pour le passage du moyen de rinçage

9. Procédé selon la revendication 1 à 8, caractérisé en ce que l'agent de rinçage est de l'eau ou une solution aqueuse.

10. Procédé selon la revendication 9, caractérisé en ce que l'eau ou la solution aqueuse est à une température de 20 à 50°C.

11. Procédé selon la revendications 1 à 10, caractérisé en ce que les buses sont des buses à faisceau plat

12. Procédé selon la revendication 11, caractérisé en ce que l'angle d'ouverture du cône de pulvérisation, dans la direction de son plus grand diamètre, est de 60 à 120 degrés.

13. Procédé selon la revendication 12 ou 13, caractérisé en ce que la direction de plus grand diamètre du cône de pulvérisation fait un angle de 75 à 85° avec la direction de transport du matériau d'enregistrement.

14. Procédé selon l'une des revendications 3 à 13, caractérisé en ce que l'agent de rinçage est pulvérisé à une vitesse de 15 à 30 m/s et à un débit de 0,8 à 2 ml par s et par cm$^2$ sur la couche d'enregistrement.

**15.** Procédé selon la revendication 1 à 14, caractérisé en ce que la couche d'enregistrement comporte une image tramée.

**16.** Dispositif pour la mise en oeuvre du procédé selon la revendication 1 à 15, muni de rouleaux d'entraînement ou de maintien disposés du côté de l'entrée et du côté de la sortie, d'un système de guidage et de transport du film et d'un ou plusieurs tubes à buses, muni(s) d'une ou plusieurs buses dirigées de façon sensiblement verticale vers le bas, caractérisé en ce que:

a) dans la zone de travail délimitée par les rouleaux d'entraînement ou de maintien du côté de l'entrée ou de la sortie est présent au moins un élément de séparation, permettant de former au moins deux zones de rinçage, et

b) comme guidage pour le transport du film est prévue une bande transporteuse, le cas échéant sans fin, qui est entraînée par les rouleaux d'entraînement du côté d'entrée et/ou de sortie,

c) dans chaque zone de rinçage, est prévu au moins un tube à buses, les buses étant disposées de telle manière que chaque élément plan de la bande transporteuse soit frappé, lors d'un passage dans cette zone de rinçage, par au moins deux cônes de pulvérisation, les cônes de pulvérisation ne venant cependant pas se toucher, avant l'impact sur la bande transporteuse.

**17.** Dispositif selon la revendication 16, caractérisé en ce que dans au moins une zone de rinçage, est prévu un tube de buses, muni de buses à faisceau plan, dont le plus grand diamètre du cône de pulvérisation forme un angle de 75 à 85 degrés avec la direction de déplacement de la bande transporteuse et dont l'angle d'ouverture du cône de pulvérisation, dans la direction de plus grand diamètre, est de 60 à 120 degrés.

**18.** Dispositif selon la revendication 16, caractérisé en ce que les buses sont des buses à faisceau de pulvérisation circulaire, et en ce que, dans au moins une zone de rinçage, sont disposés trois tubes de buses, de telle façon que les buses de chaque tube de buse soient décalées, par rapport à celle des autres tubes de buse et dans une direction perpendiculaire à la direction de transport de la bande transporteuse, d'un tiers de la distance les séparant dans cette direction.

FIG. 1

EP 0 311 063 B1

## FIG. 2

32   33   30   31

EP 0 311 063 B1

FIG. 3

35    36

34

31